# EUROPEAN PATENT APPLICATION

(11) **EP 0 566 057 A2**
(43) Date of publication of application: **20.10.1993**
(21) Application number: 93105965.3
(22) Date of filing: 13.04.1993
(51) Int. Cl.: G01R 31/308, H05K 13/08, G01B 11/26, G06F 15/70

(54) **Method of detecting alignment of IC**

(30) Priority: 13.04.1992 JP 119636/92
(71) Applicant: YOZAN INC., Tokyo 155 (JP)
(72) Inventor: Shou, Guoliang, c/o Ezel Inc., Tokyo 112 (JP); Matsumoto, Koji, c/o Ezel Inc., Tokyo 112 (JP)
(74) Representative: Grünecker, Kinkeldey, Stockmair & Schwanhäusser Anwaltssozietät

(57) **Abstract**

A detecting method of alignment of IC is provided to abstract an angle in high speed and with high precision.

It abstracts pin parts as block images by expanding, shrinking and binarizing, calculates the centers of gravity, calculates the center point of the IC and detects the inclination comparing the lines tying the centers of gravity and X-axis and Y-axis of the camera image.

## Description

### FIELD OF THE INVENTION

For example, this invention relates to a detecting method of inclination of IC when a position is determined to mount IC on a board.

### BACKGROUND OF THE INVENTION

It is necessary to determine a precise position of IC to mount IC in a predetermined position on a board, however, there was conventionally not a method for necessary measurement to determine the position of IC, especially a method to measure inclination speedily and precisely.

### SUMMARY OF THE INVENTION

This invention is invented so as to solve these conventional problems mentioned above and purposes to provide a detecting method of inclination of IC to decide a position of IC speedily and precisely.

A detecting method of inclination of IC relating to this invention abstracts only a pin part of IC by an image processing, calculates the center of gravity of the pin part, calculates the center of IC from the center of gravity and detests an inclination for determining a position.

According to a detecting method of inclination of IC relating to this invention, it is possible to detect of inclination to speedily and precisely for determining a position of IC.

### BRIEF DESCRIPTION OF THE DRAWINGS

Figure 1 is a flow-chart showing an embodiment of this invention.

Figure 2 is a conceptual diagram of an original image of IC.

Figure 3 is a conceptual diagram abstracted block image of 4 pin parts.

Figure 4 is a conceptual diagram touching with block images of pin part each other.

Figure 5 is a conceptual diagram separating a part of block image of pin.

Figure 6 is a conceptual diagram showing the center of gravity of a block image of pin and coordinates of center of IC.

Figure 7 is a conceptual diagram showing the inclination angle.
- ϑ: is an inclination angle.
- Y: is a Y-axis of an image.
- X: is a X-axis of an image

### PREFERRED EMBODIMENT OF THE PRESENT INVENTION

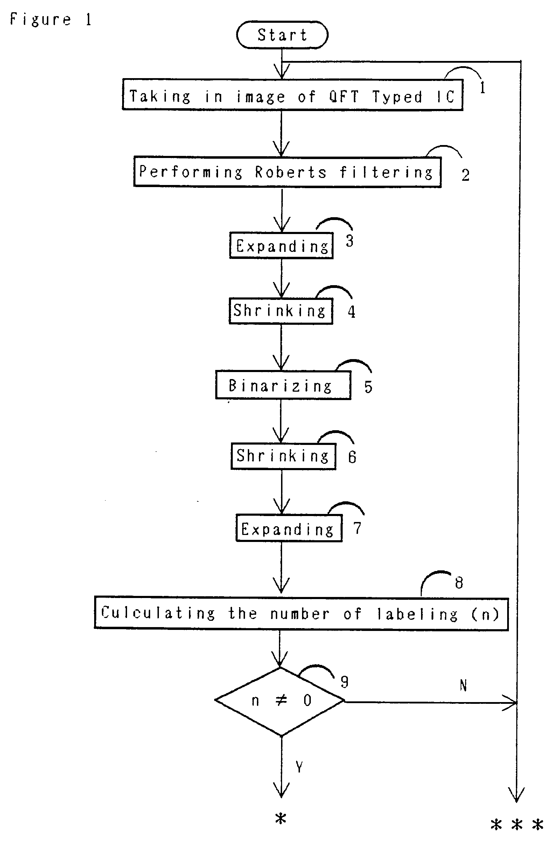

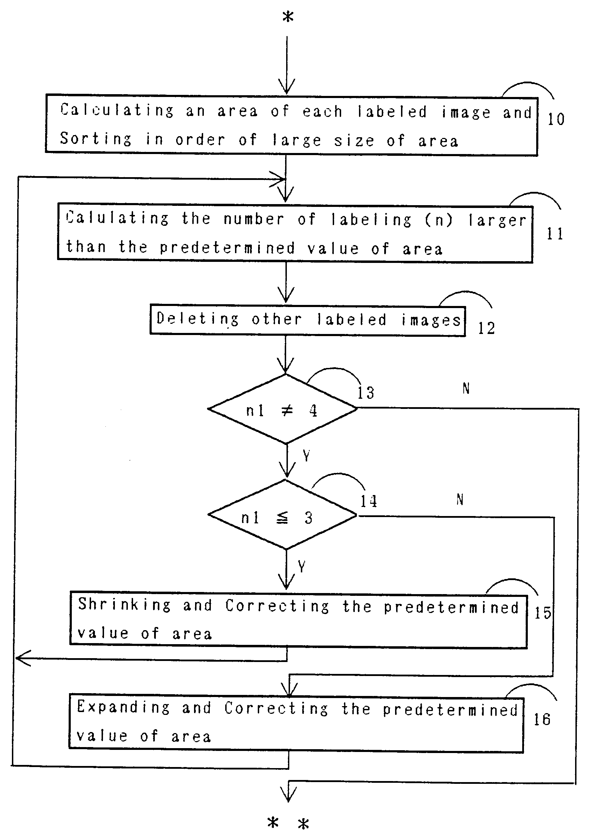

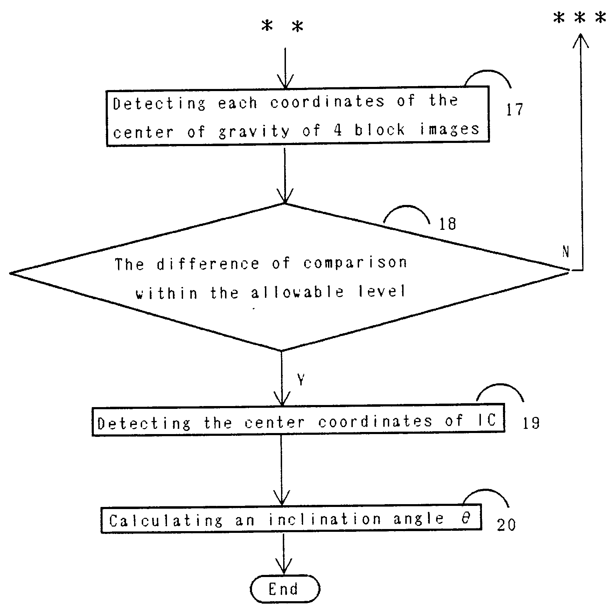

Hereinafter, an embodiment of the detecting method of inclination of IC relating to this invention is described with reference to the attached drawings. Fig. 1 is a flow-chart showing one example of an embodiment of this invention.

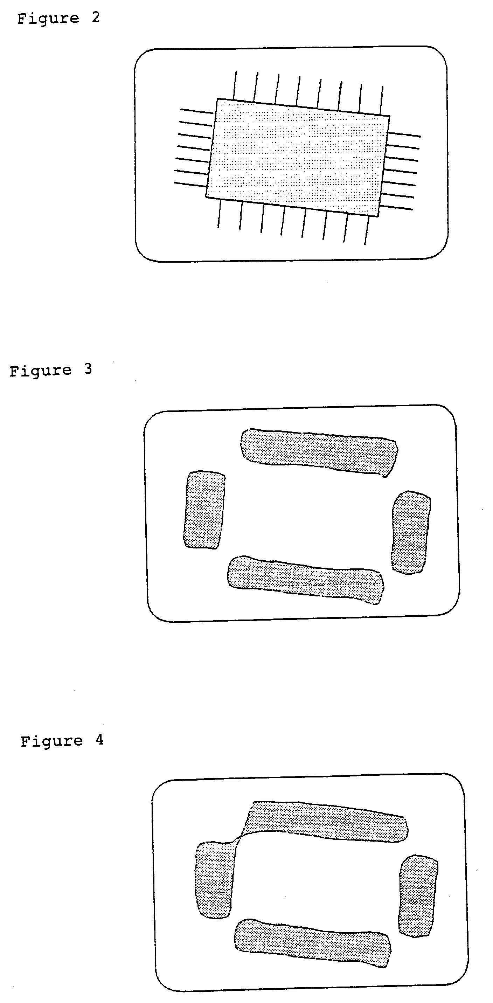

At first, the original image (Fig. 2) of QFT Typed IC is taken in on step 1. The density of a background is assumed to be almost even, and it does not have any reflection. Also the original image of the taken IC inclines a little from the vertical and the horizontal directions of an image of camera as shown in Fig. 2. Conventionally, detection of position and inclination of IC has needed time, however, it is possible to easily detect the inclination and to mount IC on a board in high speed by this invention, for example.

Roberts filtering is performed on step 2 on the image input on step 1. As a result, a part whose density of background is even has lower density, on the other hand, a part of which difference of density is large, such as a boundary between a background and a pin part of IC, the pin part with high density is emphasized.

An image performed filing is given the predetermined number of times expansion on step 3. Consequently, a chink between pins is lost because of touch of bins each other, and each of 4 parts becomes a block image.

Next, shrinking is given on step 4. Only the outer peripheral part of the pin part already become a block image on the step 3 shrinks, and it is possible to obtain a block image of the pin part almost the same as the original image.

A binarization is given by a P-tile method on step 5. In advance, it is possible to calculate an area of the block image of a pin part. A threshold value is determined to divide this pin part from the other part (a background and a part of mold). By these works, a pin part is abstracted.

Shrinking and expansion are given on steps 6 and 7, and small noise of the binarized image is deleted.

The number of labeling (n) is calculated after giving labeling on step 8.

The number of labeling (n) is judged whether it is equal to 0 or not on step 9. When n is equal to 0, the stage goes to step 1 to take in an image again because 0 means a failure of abstracting pin part for no existence of an image. When n is not equal to 0, the stage goes to step 10 while it is supposed that an image exists as a pin part.

On the step 10, an area of each labeled image is calculated and sorted in order of large size of area.

The number of labeling (n1) larger than the predetermined value of area is calculated on step 11. The value of the predetermined area is a value calculated based on the area of 1 block image of a pin part with a little number of pin, and it is in advance registered.

A labeled image over the predetermined value of area is remained and the others are deleted on step 12. In short, the images without pin part not deleted as a noise can be remained in the labeled image obtained on step 8: they are deleted here.

The number of n1 is judged whether it is equal to 4 or not on step 13. When n is equal to 4 it is judged that only a block image of 4 pin parts is abstracted (Fig. 3) and the stage goes to step 17. When n is not equal to 4, the stage goes to step 14.

The number of n1 is judged whether it is within 3 or over 5 on step 14. In the case the number n1 is within 3, a block image of 4 pin parts touches each other without being divided (Fig, 4), and the processings from step 11 to step 13 are repeated until the block image is divided into 4 pin parts after shrinking on step 15. According to the times of shrinking, the predetermined value of area is corrected in downward.

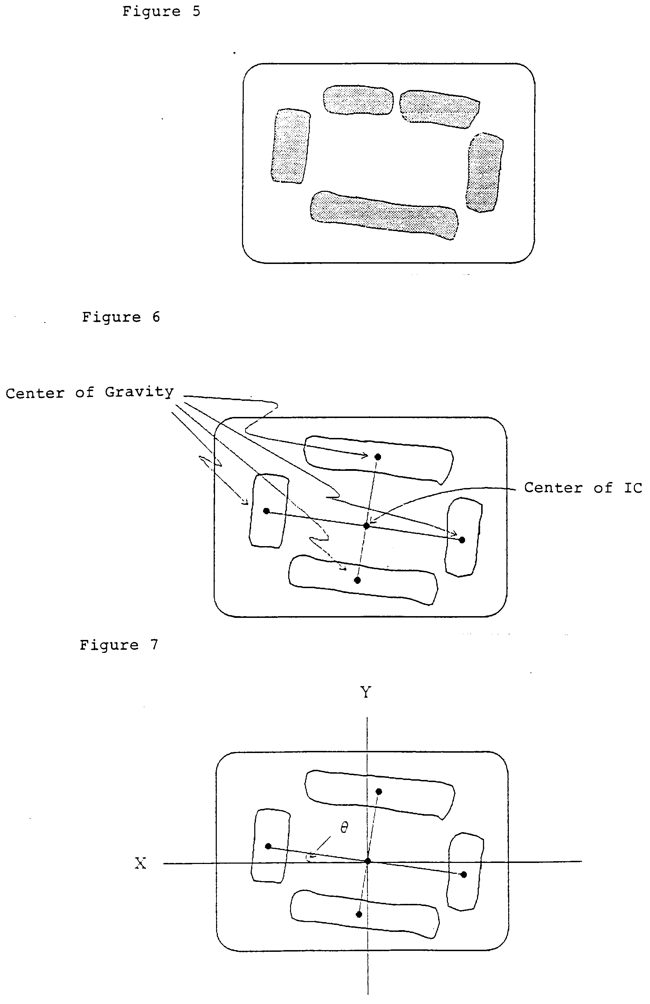

Contrary, in the case n1 is over 5, it means the separation of a part of block (Fig. 5) and expansion is given on step 16. The processings from step 11 to step 13 are repeated until the number of block is 4, According to the number of times of expansion, the predetermined value of area is corrected in upward,

Each coordinates of the center of gravity of 4 block images is detected on step 17.

The distance between the centers of gravity is measured and compared with the distance registered beforehand between the centers of gravity on step 18, In the case that difference of the comparison is within an allowable level, the stage goes to 19 because it means the abstract of the center of gravity of each pin part.

In the case the difference exceeds the allowable level, the stage goes to the step 1 to input the image again because it means the failure to abstract a precise pin part.

The crossing point tying the centers of gravity of facing pin parts is calculated and it is to be a center coordinates of IC (Fig. 6) on step 19,

Tying the center of IC and the center of gravity of pins, an inclination angle ϑ is calculated after comparing the horizontal and the vertical directions of the image of camera (Fig. 7) on step 20, As a result, it is possible to correct the inclination of IC, and to correct or to measure the other items.

According to this invention as mentioned above, by simplifying detecting an inclination and a position of IC, for example, it is possible to speedily mount an IC on a board.

## Claims

1. A detecting method of inclination of IC comprises steps of:
inputting an image of an IC:
applying expansion and shrinking by the predetermined number of times to said input image so as to generate a first processed image;
binarizing said first processed image so as to generate a second processed image;
labeling said second processed image after applying by the predetermined number of times of expansion and shurinking so as to generate a third processed image;
abstracting labeled images of predetermined number having an area in predetermined range from said third processed image so as to generate a forth processed image;
calculating a center of gravity of each said forth processed image so as to generate a fifth processed image; and
calculating a center and inclination angle of IC from the center of gravity of each said fifth processed image.
